# EUROPEAN PATENT APPLICATION

(11) **EP 2 242 104 A2**
(43) Date of publication of application: **20.10.2010**
(21) Application number: 10159078.4
(22) Date of filing: 05.04.2010
(51) Int. Cl.: H01L 27/142, H01L 31/18

(54) **Thin-film photovoltaics**

(30) Priority: 14.04.2009 US 423581
(71) Applicant: Honeywell International Inc., Morristown, NJ 07962 (US)
(72) Inventor: Zheng, Zhi, 200030, Shanghai (CN); Wang, Marilyn, 201203, Shanghai (CN); Zhao, Linan, 201204, Shanghai (CN)
(74) Representative: Buckley, Guy Julian

(57) **Abstract**

Thin-film photovoltaic cells and methods for manufacturing thin-film photovoltaic cells. An example method for manufacturing a thin-film photovoltaic cell includes providing a substrate, forming an imprinted surface on the substrate, and depositing one or more thin-film photovoltaic layers on the imprinted surface. An example thin-film photovoltaic cell may include a substrate layer having an imprinted surface, with a one or more thin-film photovoltaic layers disposed on the imprinted surface. A filler layer may be provided on the thin-film photovoltaic layer.

## Description

### Technical Field

The disclosure pertains generally to photovoltaics and/or photovoltaic cells. More particularly, the disclosure pertains to thin-film photovoltaic cells and methods for manufacturing the same.

### Background

A wide variety of photovoltaics (and/or photovoltaic cells) have been developed for converting sunlight into electricity (e.g. solar cells). Of the known photovoltaics, each has certain advantages and disadvantages. There is an ongoing need to provide alternative photovoltaics and/or photovoltaic cells as well as alternative methods for manufacturing photovoltaics and/or photovoltaic cells.

### Summary

The disclosure pertains generally to thin-film photovoltaic cells and methods for manufacturing thin-film photovoltaic cells. In some instances, photovoltaic cells may be solar cells. An example method for manufacturing a thin-film photovoltaic cell may include providing a substrate, forming an imprinted surface on the substrate, and depositing a thin-film photovoltaic layer or layers on the imprinted surface.

Another example method for manufacturing a thin-film photovoltaic cell may include providing an imprintable substrate, imprinting the substrate to define a rough surface on the substrate, depositing a thin-film photovoltaic layer or layers on the rough surface, and disposing a filler layer on the thin-film photovoltaic layer to form a substantially planar outer surface.

An example thin-film photovoltaic cell may include a substrate layer having an imprinted surface. A thin-film photovoltaic layer or layers may be disposed on the imprinted surface. In some instances, a filler layer may be disposed on the thin-film photovoltaic layer. The filler layer may have a substantially planar outer surface.

The above summary of some embodiments is not intended to describe each disclosed embodiment or every implementation of the present invention. The Figures, and Description which follow more particularly exemplify certain illustrative embodiments.

### Brief Description of the Drawings

The invention may be more completely understood in consideration of the following detailed description of various embodiments of the invention in connection with the accompanying drawings, in which:
Figure 1 is a perspective view of an example substrate for use in a photovoltaic cells;
Figure 2 is a schematic cross-sectional side view of an example photovoltaic cell;
Figure 3 is a schematic cross-sectional side view of an example substrate for use in a photovoltaic cell prior to imprinting;
Figure 4 is a schematic cross-sectional side view of the substrate in Figure 3 being imprinted by an example stamp or template;
Figure 5 is a schematic cross-sectional side view of the substrate in Figures 3-4 with a rough surface formed thereon; and
Figure 6 is a schematic cross-sectional side view of another example substrate for use in a photovoltaic cell.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the spirit and scope of the invention.

### Description

For the following defined terms, these definitions shall be applied, unless a different definition is given in the claims or elsewhere in this specification.

All numeric values are herein assumed to be modified by the term "about," whether or not explicitly indicated. The term "about" generally refers to a range of numbers that one of skill in the art would consider equivalent to the recited value (i.e., having the same function or result). In many instances, the terms "about" may include numbers that are rounded to the nearest significant figure.

The recitation of numerical ranges by endpoints includes all numbers within that range (e.g. 1 to 5 includes 1, 1.5, 2, 2.75, 3, 3.80, 4, and 5).

As used in this specification and the appended claims, the singular forms "a", "an", and "the" include plural referents unless the content clearly dictates otherwise. As used in this specification and the appended claims, the term "or" is generally employed in its sense including "and/or" unless the content clearly dictates otherwise.

The following description should be read with reference to the drawings in which similar elements in different drawings are numbered the same. The drawings, which are not necessarily to scale, depict illustrative embodiments and are not intended to limit the scope of the invention.

A wide variety of photovoltaics (and/or photovoltaic cells) have been developed for converting sunlight into electricity. Some example photovoltaics include a layer of crystalline silicon. Second and third generations of photovoltaics often utilize a thin film of photovoltaic material deposited or otherwise provided on a substrate. Thin-film photovoltaics may be categorized according to the photovoltaic material deposited. For example, inorganic thin-film photovoltaics may include a thin film of amorphous silicon, microcrystalline silicon, CdS, CdTe, Cu₂S, copper indium diselenide (CIS), copper indium gallium diselenide (CIGS), etc. Similarly, organic thin-film photovoltaics may include a thin film of a polymer or polymers, bulk heterojunctions, ordered heterojunctions, a fullerence, a polymer/fullerence blend, photosynthetic materials, etc. These are only examples.

Efficiency may play an important role in the design and production of photovoltaics. One factor that may correlate to efficiency is film thickness. In general, a thicker film is able to absorb more light. This may desirably improve efficiency of the cell. However, thicker films often lose more charges due to high internal resistance and/or increased recombination, which reduces efficiency. Thinner films may have less internal resistance and/or less recombination, but typically do not absorb light as efficiently as thicker films.

The photovoltaics and/or photovoltaic cells disclosed herein are designed to be more efficient by, for example, increasing the light absorbing ability of the film while reducing internal resistance and/or recombination. Likewise, the methods for manufacturing photovoltaics and/or photovoltaic cells disclosed herein are aimed at producing more efficient photovoltaics.

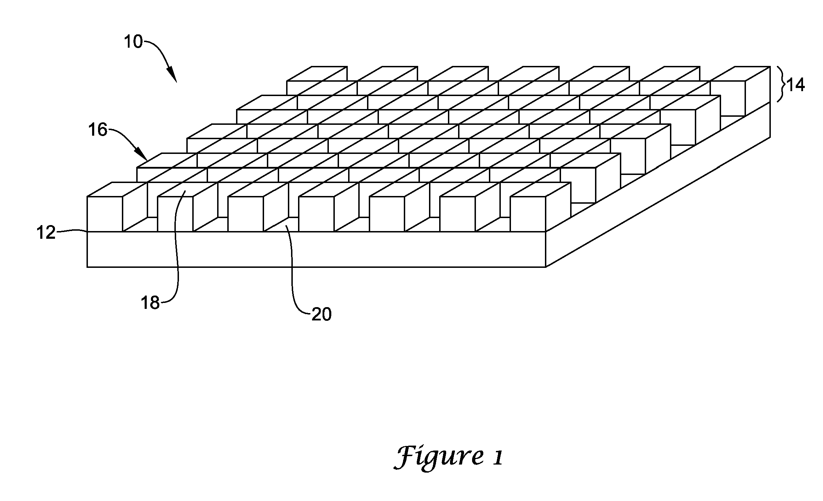

Figure 1 illustrates is a perspective view of an illustrative substrate 12 for use in manufacturing a photovoltaic cell 10. Substrate 12 may include a top portion 14 that is imprinted or otherwise altered so as to define a "rough" surface 16. For the purposes of this disclosure, a "rough" surface may be understood as having an increased surface area relative to a planar surface, and may include one or more projections and/or impressions, being textured, being irregular, have surface features and/or irregularities, or otherwise having a roughened non-planar surface. The shapes, patterns, and/or arrangements of the surface features of rough surface 16 may vary widely and include essentially any suitable arrangement that increases the effective surface area of top portion 14 of the substrate 12.

As shown in Figure 1, rough surface 16 may define a plurality of projections 18 and a plurality of impressions 20 formed in top portion 14. In at least some embodiments, top portion 14 may be substantially planar prior to forming projections 18 and impressions 20 therein. Depending on the method utilized for forming rough surface 16, either projections 18 or impressions 20 may correspond to the "normal" or unaltered planar top portion 14. Alternatively, neither projections 18 nor impressions 20 may correspond to the planar top portion 14.

Forming rough surface 16 in substrate 12 may be desirable for a number of reasons. For example, by increasing the surface area of top portion 14 (e.g., by "roughening" top portion 14), a greater amount of surface area is available for the depositing of a thin-film photovoltaic material relative to an unaltered planar top portion 14. Thus, a greater surface area of the thin-film photovoltaic material may be deposed on substrate 12 with rough surface 16 than a substrate having a substantially planar surface. By increasing the surface area available for deposition of a thin-film photovoltaic onto substrate 12 (and, thus, increasing the area of the thin-film photovoltaic layer deposited thereon), a greater amount of light can be absorbed by the thin-film photovoltaic. This may desirably increase the efficiency of the corresponding layer of thin-film photovoltaics and/or the efficiency of cell 10. In other words, the thin-film photovoltaic layer deposited on rough surface 16 may act like or mimic the light-absorbing ability of a thicker film (due to its increased surface area and corresponding increased light-absorbing ability) while remaining sufficiently thin so as to reduce or otherwise minimize the internal resistance and/or recombination of the film.

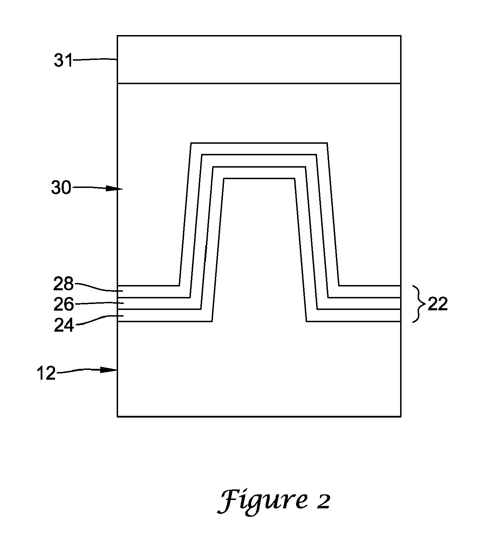

Figure 2 is a side view of a portion of cell 10 that depicts that a thin-film photovoltaic and/or photovoltaic layer(s) 22 deposited on substrate 12. Here it can be seen that the photovoltaic layer(s) 22 may include an electron conductor layer 24, an active layer 26, and a hole conductor layer 28. Layers 24/26/28 may vary depending on the type of photovoltaic utilized for cell 10. For example, electron conductor layer 24 may be a metallic and/or semiconducting material, such as TiO₂ or ZnO. Alternatively, electron conductor layer 24 may be an electrically conducting polymer such as a polymer that has been doped to be electrically conducting and/or to improve its electrical conductivity. In at least some embodiments, electron conductor layer 24 may include a n-type conductor and/or form or otherwise be adjacent to the anode (negative electrode) of cell 10.

Active layer 26 may vary widely in composition depending on the type of photovoltaic cell utilized. For example, active layer 26 may include a thin film or layer of crystalline silicon, amorphous silicon, microcrystalline silicon, CdS, CdTe, Cu₂S, a transparent conductive oxide, copper indium diselenide (CIS), copper indium gallium diselenide (CIGS), etc., a polymer or polymers, bulk heterojunctions, ordered heterojunctions, a fullerence, a polymer/fullerence blend, photosynthetic materials, combinations thereof, and the like, or any other suitable active layer 26.

In some embodiments, active layer 26 may include a quantum dot or a plurality of quantum dots. Quantum dots are typically very small semiconductors, having dimensions in the nanometer range. Because of their small size, quantum dots may exhibit quantum behavior that is distinct from what would otherwise be expected from a larger sample of the material. In some cases, quantum dots may be considered as being crystals composed of materials from Groups II-VI, III-V, or IV-VI materials. The quantum dots employed may be formed using any appropriate technique. Examples of specific pairs of materials for forming quantum dots include, but are not limited to, MgO, MgS, MgSe, MgTe, CaO, CaS, CaSe, CaTe, SrO, SrS, SrSe, SrTe, BaO, BaS, BaSe, BaTe, ZnO, ZnS, ZnSe, ZnTe, CdO, CdS, CdSe, CdTe, HgO, HgS, HgSe, HgTe, Al₂O₃, Al₂S₃, Al₂Se₃, Al₂Te₃, Ga₂O₃, Ga₂S₃ Ga₂Se₃ Ga₂Te₃, In₂O₃, In₂S₃ In₂Se₃, In₂Te₃, SiO₂, GeO₂, SnO₂, SnS, SnSe, SnTe, PbO, PbO₂, PbS, PbSe, PbTe, AIN, AIP, AlAs, AlSb, GaN, GaP, GaAs, GaSb, InN, InP, InAs and InSb.

The size or thickness of active layer 26 may also vary. In at least some embodiments, active layer 26 may have a thickness in the micrometer range (e.g., about 0.1 to about 10 micrometers). In other embodiments, active layer 26 may be in the nanometer range (e.g., about 0.1 to about 10 nanometers). In still other embodiments, active layer 26 may fall between the micrometer range and the nanometer range or fall outside of the given ranges. It can be appreciated that the relative thickness of active layer 26 may determine the methodology utilized to form rough surface 16 on substrate 12. For example, for "thinner" active layers 26 (e.g., in the nanometer range), nano-imprinting techniques may be utilized, whereas for "thicker" active layers 26 (e.g., in the micrometer range), micro-imprinting technologies may be utilized.

Hole conductor layer 28 may be configured to reduce active layer 26 once active layer 26 has absorbed a photon and ejected an electron to electron conductor layer 24. In at least some embodiments, hole conductor layer 28 may include a p-type conductor and/or form or otherwise be adjacent to the cathode (positive electrode) of cell 10. In some instances, hole conductor layer 28 may be a conductive polymer, but this is not required. The conductive polymer may, for example, be or otherwise include a functionalized polythiophene.

An illustrative but non-limiting example of a suitable conductive polymer has 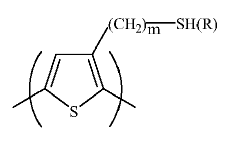 as a repeating unit, where R is absent or alkyl and m is an integer ranging from about 6 to about 12. The term "alkyl" refers to a straight or branched chain monovalent hydrocarbon radical having a specified number of carbon atoms. Examples of "alkyl" include, but are not limited to, methyl, ethyl, n-propyl, isopropyl, n-butyl, s-butyl, t-butyl, n-pentyl, n-hexyl, 3-methylpentyl, and the like.

Another illustrative but non-limiting example of a suitable conductive polymer has 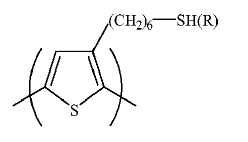 as a repeating unit, where R is absent or alkyl.

Another illustrative but non-limiting example of a suitable conductive polymer has 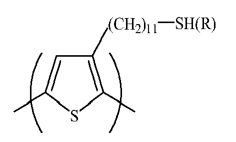 as a repeating unit, where R is absent or alkyl.

Another illustrative but non-limiting example of a suitable conductive polymer has 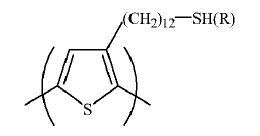 as a repeating unit, where R is absent or alkyl.

Numerous variations are contemplated for thin-film photovoltaic layer 22 including the use or inclusion of essentially any suitable thin-film photovoltaic material.

Also illustrated in Figure 2 is a filler layer 30, which may be disposed on photovoltaic layer(s) 22. Filler layer 30 may have a substantially planar outer surface so that it can help fill in or otherwise effectively flatten the top surface of cell 10. A back sheet or layer 31 may be disposed on filler layer 30, if desired.

Filler layer 30 may be made from a number of different materials. In at least some embodiments, filler layer 30 may include ethylene vinyl acetate. However, essentially any suitable material may be utilized. In general, it may be desirable for filler layer 30 to be substantially transparent to the light of interest. In some cases, filler layer 30 may have a refractive index, relative to the refractive index of its surrounding layers, that helps reduce light reflection loss at the layer interfaces, if desired.

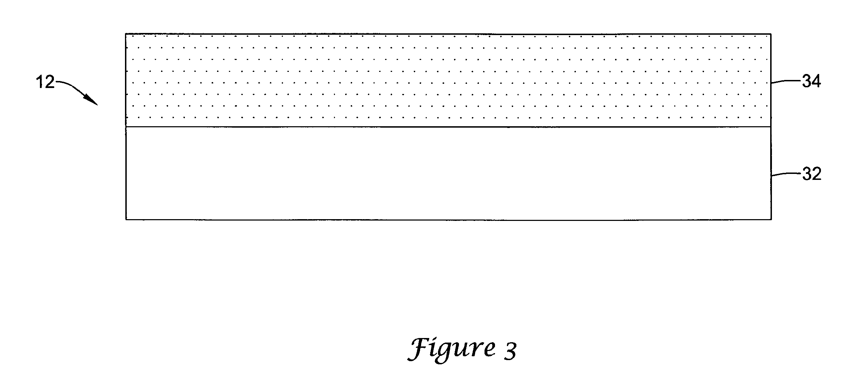

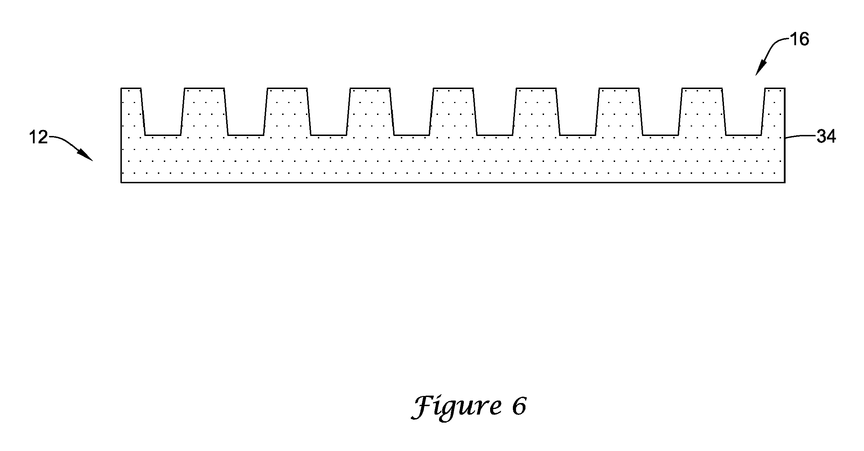

Figures 3-6 schematically show at least some illustrative methods for manufacturing cell 10. Figure 3 shows a substrate 12. In this illustrative embodiment, substrate 12 includes a first layer 32 and a second layer 34 disposed on the first layer 32. In some cases, first layer 32 may be glass, and the second layer 34 may include a material or surface that may be "roughened" or imprinted using, for example, any suitable technique. For example, second layer 34 may include an imprintable polymer such as polyimide. Other suitable materials including other polymers may also be used, as desired. Second layer 34 may correspond to top portion 14 discussed above. Substrate 12 may also include one or more additional layers, if desired. These layers may or may not be imprintable or imprinted. Other substrates are also contemplated that lack first layer 32 and only include an imprintable second layer 34, such as shown in Figure 6.

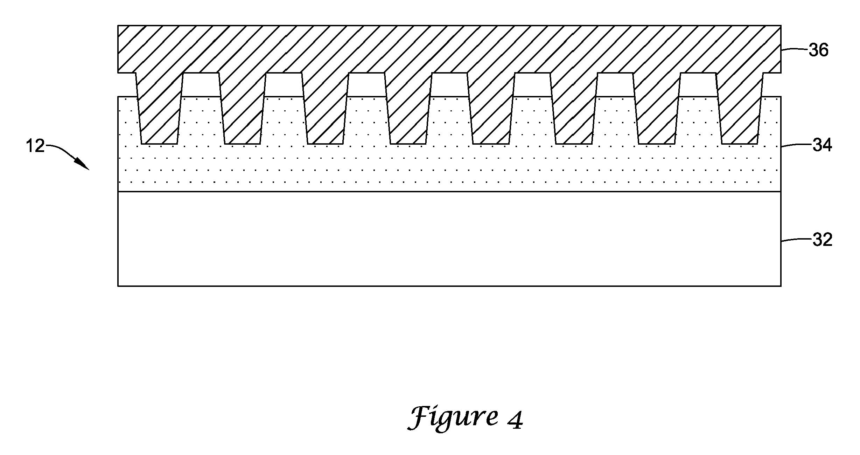

An example method for manufacturing cell 10 may include providing substrate 12 and forming rough surface 16 on substrate 12. Forming rough surface 16 may include any of a variety of different methods. For example, rough surface 16 may be formed by hot embossing, soft lithography, micro-contact imprinting, ultraviolet lithographical imprinting, and the like, or using any other suitable method as desired. In one example, Figure 4 illustrates a stamp (e.g., a polydimethylsiloxane stamp) or template 36 being brought into contact with top portion 14 of substrate 12. Stamp 36 may press into top portion 14 and imprint substrate 12 so as to form a rough surface 16 (e.g., upon removal). For the purpose of this disclosure, imprinting may be understood as being a method that alters the surface characteristics of top portion 14 and forms rough surface 16. Imprinting may or may not include heating.

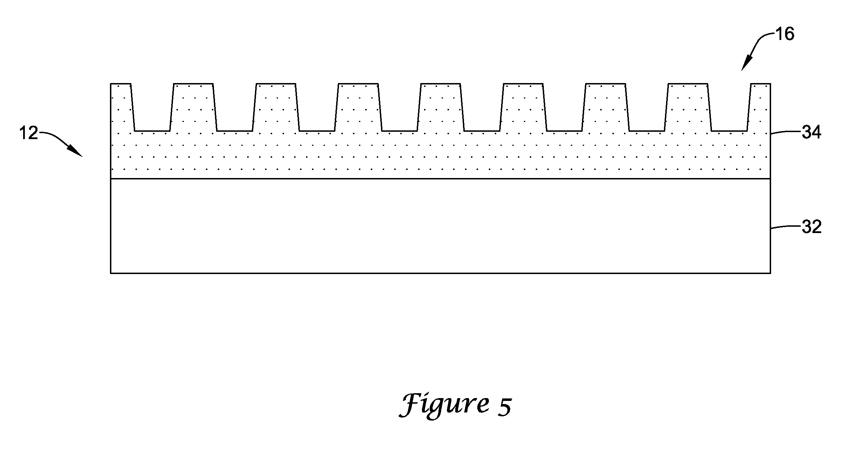

In Figure 4, and to facilitate the forming of rough surface 16, top portion 14 (e.g., second layer 34) may be disposed in a liquid state, partially liquefied state, or softened state on first layer 32. This may help stamp 36 to more easily press into substrate 12 and form rough surface 16. Following the imprinting step, substrate 12 may be cross-linked or otherwise solidified to form a solid rough surface 16, such as shown in Figure 5. Alternatively, second layer 34 may be provided in a substantially solid state and the imprinting step may include the addition of heat to facilitate the formation of rough surface 16. In some cases, the rough surface 16 may be formed by removing some material, such as through grinding, etching or any other suitable technique, as desired. Once rough surface 16 is formed, substrate 12 may be ready for deposition of thin-film photovoltaic layer(s) 22, such as shown in Figure 2.

Figure 6 shows an illustrative embodiment where substrate 12 itself is roughened, rather than a second layer 34 on the substrate. Once roughened, and in some cases, the roughened substrate 12 may be secured to another layer, such as a glass layer before depositing or otherwise providing thin-film photovoltaic layer(s) 22 thereon, but this is not required.

Regardless of the form of substrate 12 utilized, once rough surface 16 is formed, thin-film photovoltaic layer(s) 22 may be deposited or otherwise provided on rough surface 16. Subsequently, and in some cases, one or more filler layer(s) 30 may be disposed on thin-film photovoltaic layer(s) 22 to form cell 10, but this is not required. In some cases, a backing 31 may also be provided on filler layer 30 if desired.

Figures 3-6 illustrate a number of illustrative methods for manufacturing photovoltaic cell 10. For example, a first method may include coating a liquid imprintable substrate layer 34 onto first layer 32 (e.g., glass first layer 32), imprinting layer 34 by soft lithography using a polydimethysiloxane stamp, and solidifying (e.g. cross-linking) layer 34 to form rough surface 16. Another example method may include coating a liquid imprintable substrate layer 34 onto first layer 32 (e.g., glass first layer 32), imprinting layer 34 by hot embossing, and solidifying (e.g. cross-linking) layer 34 to form rough surface 16. Another example method may include imprinting layer 34 (e.g., a polyimide film) by soft lithography or hot embossing and then adhering layer 34 (having rough surface 16 defined thereon) onto a first layer 32 (e.g., glass first layer 32). Yet another example method may include imprinting layer 34 (e.g., a polyimide film) by soft lithography or hot embossing and using layer 34 (having rough surface 16 defined thereon) directly as substrate 12.

While the cells 10 and method for manufacturing cells 10 disclosed herein are described in terms of photovoltaic cells, it can be appreciated that this disclosure is also applicable to other thin-film devices such as light emitting diodes (LED's). Consequently, to the extent applicable, this disclosure may analogously by applied to LED and other thin film devices, if desired.

It should be understood that this disclosure is, in many respects, only illustrative. Changes may be made in details, particularly in matters of shape, size, and arrangement of steps without exceeding the scope of the invention. The invention's scope is, of course, defined in the language in which the appended claims are expressed.

## Claims

1. A method for manufacturing a thin-film photovoltaic cell (10), the method comprising:
providing a substrate (12);
forming a imprinted surface (16) on the substrate (12); and
depositing one or more thin-film photovoltaic layers (22) on the imprinted surface (16).

2. The method of claim 1, wherein the substrate (12) includes polyimide.

3. The method of claim 1, wherein the substrate (12) includes a non-imprintable portion (32) and an imprintable portion (34).

4. The method of claim 3, wherein the non-imprintable portion (32) includes glass.

5. The method of claim 3, wherein the imprintable portion (34) includes polyimide.

6. The method of claim 1, wherein forming the imprinted surface (16) on the substrate (12) includes one or more of hot embossing, soft lithography, micro-contact imprinting, and ultraviolet lithographical imprinting.

7. The method of claim 1, further comprising disposing a filler layer (30) on the one or more thin-film photovoltaic layers (22) to form a substantially planar top surface.

8. The method of claim 7, wherein the filler layer (30) is substantially transparent to a wavelength of interest.

9. The method of claim 1, wherein the one or more thin-film photovoltaic layers (22) include a hole conductor layer (28), an active layer (26) and an electron conductor layer (24).

10. A method for manufacturing a thin-film photovoltaic cell (10), the method comprising:
providing an imprintable substrate (12);
imprinting the substrate (12) to define a rough surface (16) on the substrate (12);
providing one or more thin-film photovoltaic layer (22) on the rough surface (16); and
providing a filler layer (30) on the one or more thin-film photovoltaic layer (22) to form a substantially planar top surface.
